(19) Europäisches Patentamt
European Patent Office
Office européen des brevets

(11) **EP 4 428 896 A1**

(12) **EUROPEAN PATENT APPLICATION**

(43) Date of publication:
**11.09.2024 Bulletin 2024/37**

(21) Application number: **24162043.4**

(22) Date of filing: **07.03.2024**

(51) International Patent Classification (IPC):
**H01J 37/304** (2006.01)     **H01J 37/317** (2006.01)

(52) Cooperative Patent Classification (CPC):
**H01J 37/3045; H01J 37/3174;** H01J 2237/024;
H01J 2237/24507; H01J 2237/3045;
H01J 2237/31774

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.03.2023 EP 23160722**

(71) Applicant: **IMS Nanofabrication GmbH 2345 Brunn am Gebirge (AT)**

(72) Inventor: **Platzgummer, Elmar 1090 Wien (AT)**

(74) Representative: **Patentanwaltskanzlei Matschnig & Forsthuber OG Biberstraße 22 Postfach 36 1010 Wien (AT)**

(54) **DEVICE AND METHOD FOR CALIBRATING A CHARGED-PARTICLE BEAM**

(57)     A beam calibration device (140) is presented for calibrating a charged-particle beam in a charged-particle processing apparatus in relation to a positioning of the beam with respect to a target. The beam calibration device includes a detector (145) for the charged particles that are arriving at a registering structure (143) of said device. The beam is deflected from a designated target position towards the device, by means of a lateral initial deflection, thus allowing the beam to impinge on at least one of the registering structures. The beam is scanned over the beam calibration device (140), thus covering a pre-defined region on this device including the registering structure, and using the detector, an electric current is measured as a current signal and is evaluated, to determine a central relative position of the beam with respect to an optimal position predefined on the beam calibration device surface. Using this optimal position, the beam is deflected back to the designated target position by a reverse lateral deflection which is an inverse of said initial deflection combined with a deflection correction, which represents a correction of the lateral beam position to compensate the central relative position.

Fig. 3A

**Description**

Field of the invention and description of prior art

The invention relates to certain improvements in the control of process parameters in a multi-beam charged particle processing apparatus. More specifically, the invention relates to a method for calibrating a charged-particle beam, in particular an electron beam, in a charged-particle processing apparatus or charged-particle multi-beam processing apparatus, which is configured for the exposure of a target by means of a structured beam of electrically charged particles.

In a charged-particle multi-beam processing apparatus, a particle beam is generated in a charged-particle source, is directed to and illuminates a pattern definition device comprising an aperture array composed of a multitude of blanking apertures through which the particle beam penetrates, and is then imaged by a projection optics system onto a target, for writing a desired pattern on the target by exposing a multitude of pixels by means of the particle beam impinging on the target within a beam field of the target.

The applicant has realized charged-particle multi-beam tools of the mentioned type and developed corresponding charged-particle optics, pattern definition (PD) device, and multi-beam writing method, in particular a 50keV electron multi-beam writer to realize leading-edge complex photomasks for 193nm immersion lithography, masks for EUV lithography and templates (1x masks) for imprint lithography. The system is called eMET (electron Mask Exposure Tool) or MBMW (multi-beam mask writer) for exposing 6" mask blank substrates. The multi-beam system has been called PML2 (Projection Mask-Less Lithography) for electron beam direct writer (EBDW) applications on Silicon wafer substrates. The multi-beam column and writing method can also be used for multi-beam inspection applications.

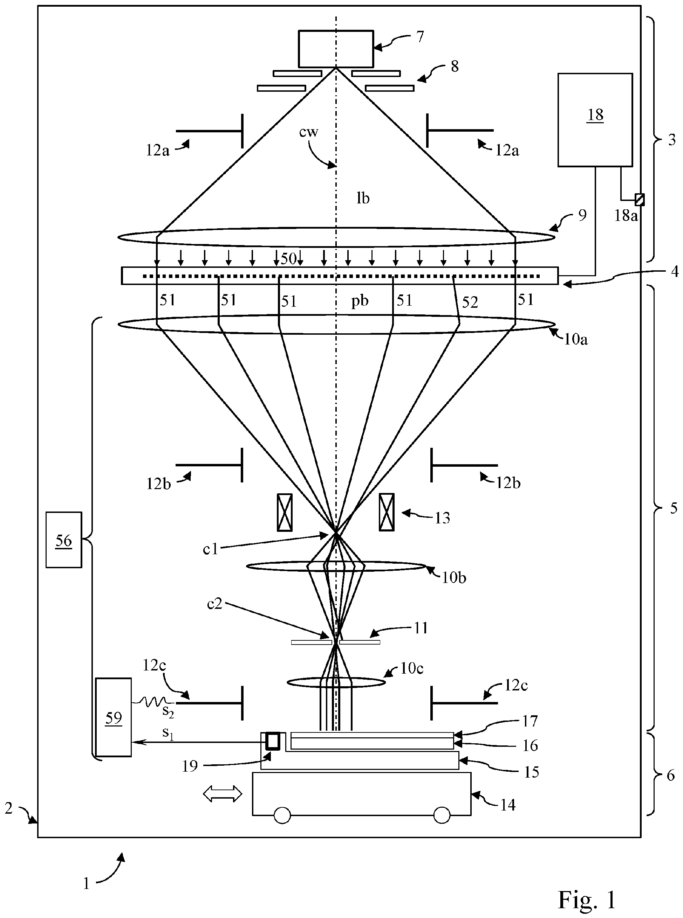

Exemplary schematics of the multi-beam writer are shown in Fig. 1. Such a lithographic apparatus is well known in prior art, such as US 6,768,125 , EP 2 187 427 A1 (= US 8,222,621) and EP 2 363 875 A1 (= US 8,378,320). In the following, only those details are given as needed to disclose the invention; for the sake of clarity, the components are not shown to size in Fig. 1. The main components of the lithography apparatus 1 are - corresponding to the direction of the lithography beam lb, pb which in this example runs vertically downward in Fig. 1 - an illumination system 3 including the charged-particle source, a pattern definition (PD) system 4, a projecting system 5, and a target station 6 with a substrate 16 serving as target. The whole apparatus 1 is contained in a vacuum housing 2 held at high vacuum to ensure an unimpeded propagation of the beam lb, pb along the optical axis cw of the apparatus. The charged-particle optical systems 3, 5 are realized using electrostatic and/or magnetic lenses.

The illumination system 3 comprises, for instance, an electron gun 7, an extraction system 8 as well as a condenser lens system 9. It should, however, be noted that in place of electrons, in general, other electrically charged particles can be used as well. Apart from electrons these can be, for instance, hydrogen ions or heavier ions, charged atom clusters, or charged molecules.

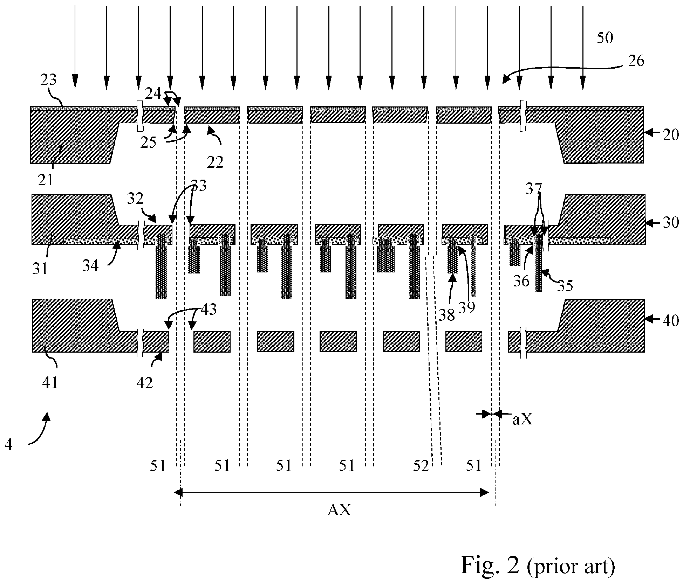

The extraction system 8 accelerates the particles to a defined energy of typically several keV, e.g. 5 keV. By means of a condenser lens system 9, the particles emitted from the source 7 are formed into a wide, substantially telecentric particle beam 50 serving as lithography beam lb. The lithography beam lb then irradiates a PD system 4 which comprises a number of plates with a plurality of openings or apertures 24 (Fig. 2). The PD system 4 is held at a specific position in the path of the lithography beam lb, which thus irradiates the plurality of apertures and is split up into a number of beamlets.

Referring to Fig. 2, some of the apertures 24 of the PD system 4 are "switched on" or "open" so as to be transparent to the incident beam in the sense that they allow the portion of the beam (beamlets 51) that is transmitted through it to reach the target; the other apertures are "switched off" or "closed", i.e. the corresponding beamlets 52 cannot reach the target, and thus effectively these apertures and/or openings are non-transparent (opaque) to the beam. Thus, the lithography beam lb is structured into a patterned beam pb, emerging from the PD system 4. The pattern of switched on apertures - the only portions of the PD system 4 which are transparent to the lithography beam lb - is chosen according to a pattern which is to be exposed on the target 16. It has to be noted that the "switching on/off" of the beamlets usually is realized by some sort of deflection means provided in one of the plates of the PD system 4: "Switched off"-beamlets are deflected off their path (by very small angles) so they cannot reach the target but are merely absorbed somewhere in the lithography apparatus, e.g. by an absorbing plate 11.

The pattern as represented by the patterned beam pb is then projected by means of an electro-magneto-optical projection system 5 onto the substrate 16 where it forms an image of the "switched-on" apertures and/or openings. The projection system 5 implements a demagnification of, for instance, 200:1 with two crossovers c1 and c2. The substrate 16 used as target is, for instance, a 6" mask blank or a silicon wafer covered with a particle sensitive resist layer 17. The target is held by a chuck 15 and positioned by a substrate stage 14 of the target station 6. In the following, the terms "substrate" and "target" are used interchangeably, referring to any substrate placed at the target position in the processing apparatus.

The information regarding the pattern to be exposed is supplied to the PD system 4 by a data path realized by means of an electronic pattern information processing system 18 (see also the description of the data path below).

In the embodiment shown in Fig. 1, the projection system 5 is composed of a number of consecutive electro-magneto-optical projector stages 10a, 10b, 10c, consisting of electrostatic and/or magnetic lenses and other deflection means, and is controlled by a projections controller 56, which is, for instance, a dedicated controlling computer or part of an optics controller (not shown) of the entire apparatus 1. These lenses and means are shown in symbolic form only, since their application is well known in the prior art. The projection system 5 employs a demagnifying imaging through crossovers c1, c2. The demagnification factor for both stages is chosen to achieve an overall demagnification of several hundreds, e.g. 200: 1. A demagnification of this order is in particular suitable with a lithography setup, in order to alleviate problems of miniaturization in the PD device.

In the whole projection system 5, provisions are made to extensively compensate chromatic and geometric aberrations. As a means to shift the image laterally as a whole, i.e. along a direction perpendicular to the optical axis cw, deflection means 12a, 12b and 12c are provided in the condenser 3 and projection system 5. The deflection means can be realized as, for instance, a multipole electrode system which is positioned near the source extraction system (12a), near the first crossover, as shown in Fig. 1 with the deflection means 12b, and/or after the final lens 10c of the respective projector, as in the case with the stage deflection means 12c in Fig. 1. In this apparatus, a multipole electrode arrangement is used as deflection means both for shifting the image in relation to the stage motion and for correction of the imaging system in conjunction with the charged-particle optics alignment system. These deflection means 12a, 12b, 12c are not to be confused with the deflection array means of the PD system 4 which, in conjunction with the stopping plate 11, are used to switch selected beamlets of the patterned beam pd to "on" or "off" state, since the former only deal with the particle beam as a whole.

There is also the possibility to rotate the ensemble of programmable beams using a solenoid 13 ("air-coil") providing an axial magnetic field.

As can be seen in the sectional detail of Fig. 2, the PD system 4 preferably comprises three plates stacked in a consecutive configuration: An "Aperture Array Plate" (AAP) 20, a "Deflection Array Plate" (DAP) 30 and a "Field-boundary Array Plate" (FAP) 40. It is worthwhile to note that the term 'plate' refers to an overall shape of the respective device, but does not necessarily indicate that a plate is realized as a single plate component even though the latter is usually the preferred way of implementation; still, in certain embodiments, a 'plate', such as the aperture array plate, may be composed of a number of sub-plates, for instance, two movable sub-plates which enable beamlet sizes switchable in-situ, cf. US 8,546,767 by the applicant. The plates are preferably arranged parallel to each other, at mutual distances along the Z direction.

The flat upper surface of AAP 20 forms a defined potential interface to the condenser optics/illumination system 11. The AAP may, e.g. be made from a square or rectangular piece of a silicon wafer (approx. 1mm thickness) 21 with a thinned center part 22. The plate may be covered by an electrically conductive protective layer 23 which will be particularly advantageous when using hydrogen or helium ions (cf. US 6,858,118). When using electrons or heavy ions (e.g. argon or xenon), the layer 23 may also be of silicon provided by the surface section of 21 and 22, respectively, so that there is no interface between layer 23 and bulk parts 21,22, respectively.

The AAP 20 is provided with a plurality of apertures 24 realized as openings traversing the thinned part 22. In the embodiment shown the apertures 24 are realized having a straight profile fabricated into the layer 23 and a "retrograde" profile in the bulk layer of the AAP 20 such that the downward outlets 25 of the openings are wider than in the main part of the apertures 24. Both the straight and retrograde profiles can be fabricated with state-of-the-art structuring techniques such as reactive ion etching. The retrograde profile strongly reduces mirror charging effects of the beam passing through the opening.

The DAP 30 is a plate provided with a plurality of openings 33, whose positions correspond to those of the apertures 24 in the AAP 20, and which are provided with electrodes 35, 38 configured for deflecting the individual sub-beams passing through the openings 33 selectively from their respective paths. The DAP 30 can, for instance, be fabricated by post-processing a CMOS wafer with an ASIC circuitry. The DAP 30 is, for instance, made from a piece of a CMOS wafer having a square or rectangular shape and comprises a thicker part 31 forming a frame holding a center part 32 which has been thinned (but may be suitably thicker as compared to the thickness of 22). The aperture openings 33 in the center part 32 are wider compared to the apertures 24 (by approx. 2 $\mu$m at each side for instance). CMOS electronics 34 is used to control the electrodes 35, 38, which are provided by means of MEMS techniques. Adjacent to each opening 33, a "ground" electrode 35 and a deflection electrode 38 are provided. The ground electrodes 35 are electrically interconnected, connected to a common ground potential, and comprise a retrograde part 36 to prevent charging and an isolation section 37 in order to prevent unwanted shortcuts to the CMOS circuitry. The ground electrodes 35 may also be connected to those parts of the CMOS circuitry 34 which are at the same potential as the silicon bulk portions 31 and 32.

The deflection electrodes 38 are configured to be selectively applied an electrostatic potential; when such electrostatic potential is applied to an electrode 38, this will generate an electric field causing a deflection upon the corresponding sub-beam, deflecting it off its nominal path. The electrodes 38 as well may have a retrograde section 39 in order to avoid charging. Each of the electrodes 38 is connected at its lower part to a respective contact site within the CMOS circuitry 34.

The height of the ground electrodes 35 is higher than the height of the deflection electrodes 38 in order to suppress cross-talk effects between the beams.

The arrangement of a PD system 12 with a DAP 30 having electrodes oriented downstream as shown in Fig. 2 is only one of several possibilities. Further DAP configurations, e.g. with embedded ground and deflection electrodes, can easily be devised by the skilled person (see other patents in the name of the applicant, such as US 8,198,601).

The third plate 40 serving as FAP has a flat surface facing to the first lens part of the downstream demagnifying charged-particle projection optics and thus provides a defined potential interface to the first lens 16a of the projection optics. The thicker part 41 of FAP 40 is a square or rectangular frame made from a part of a silicon wafer, with a thinned center section 42. The FAP 40 is provided with a plurality of openings 43 which correspond to the openings 24, 33 of the AAP 20 and DAP 30 but are wider as compared to the latter.

The PD system 4, and in particular the first plate thereof, the AAP 20, is illuminated by a broad charged particle beam 50 (herein, "broad" beam means that the beam is sufficiently wide to cover the entire area of the aperture array formed in the AAP), which is thus divided into many thousands of micrometer-sized beams 51 when transmitted through the apertures 24. The beamlets 51 and 52 will traverse the DAP and FAP unhindered.

As already mentioned, whenever a deflection electrode 38 is powered through the CMOS electronics, an electric field will be generated between the deflection electrode and the corresponding ground electrode, leading to a small but sufficient deflection of the respective beam 52 passing through (Fig. 2). The deflected beam can traverse the DAP and FAP unhindered as the openings 33 and 43, respectively, are made sufficiently wide. However, the deflected beam 52 is filtered out at the stopping plate 15 of the sub-column (Fig. 1). Thus, only those beams which are unaffected by the DAP will reach the target.

The reduction factor of the demagnifying charged-particle optics 5 is chosen suitably in view of the dimensions of the beams and their mutual distance in the PD device 4 and the desired dimensions of the structures at the target. This will allow for micrometer-sized beams at the PD system whereas nanometer-sized beams are projected onto the target.

The ensemble of (unaffected) beams 51 as formed by AAP is projected to the target with a predefined reduction factor R of the projection charged-particle optics.

It is worthwhile to note that the individual beams 51, 52 depicted in Fig. 2 are representative of a much larger number of sub-beams, typically many thousands, arranged in a two-dimensional X-Y array.

As a typical implementation of an MBMW, the applicant has realized a 50keV electron MBMW with charged particle optics providing a reduction factor of R = 200 for 512 × 512 (262,144) programmable beamlets of 20nm beam size within a beam field of $81.92\mu m \times 81.92\mu m$ at the target, which corresponds to a of $4\mu m \times 4\mu m$ opening size in the aperture array plate (AAP). For the realized writer system the target is, e.g., a substrate realized by a 6" mask blank (area: 6" × 6" = 152.4mm × 152.4mm, thickness: 1"/4 = 6.35mm) covered with an electron beam sensitive resist. Furthermore, in the realized system of the applicant multi-beam writing is possible on resist covered 150mm Si wafers.

The first generation MBMW production tools are targeted to use 20nm and 10nm beams providing up to approx. 1 $\mu$A current for all 262,144 programmable beams "on". For following generations of MBMW production tools there is the plan to use even smaller beam size of e.g. 8nm and concurrently to provide e.g. 640 × 640 = 409,600 beamlets within the $81.92\mu m \times 81.92 \mu m$ beam field at the target.

The inventors found that proper control of imaging errors can be improved by means of a dedicated in-situ device for measuring the exact position of the beam with respect to the plane where the target is to be positioned ("target plane") in the respective writer system (charged-particle processing apparatus). Therefore, it is an aim of the present invention to present approaches for determining an exact positioning of a charged-particle (electron) beam with respect to one or more desired positions at the target.

<u>Summary of the invention</u>

The above-stated aim is met by a method for calibrating a charged-particle beam in a charged-particle processing apparatus in relation to a positioning of the charged-particle beam with respect to a target plane of the processing apparatus, wherein the method comprises the steps of

    providing a beam calibration device, which includes a detector for the charged particles impinging on the device and arriving at at least one registering structure provided in a surface of this device, and positioning the beam calibration device to have the device surface substantially in the target plane of the processing apparatus; generating a beam of charged particles in the processing apparatus, where this beam has a predefined shape, and imaging this beam to the target plane at a designated target position; deflecting the beam from the designated target position to the beam calibration device, by means of a predefined lateral initial deflection, which lateral deflection is transversal to the beam direction, thus allowing the beam to impinge on at least one of the registering structure(s);

performing a scan of the beam on the beam calibration device, thus covering a pre-defined region on the device which includes the registering structure(s);

measuring, using the detector, an electric current caused by the beam during the scan, to obtain a current signal as a function of the position in the mentioned region;

evaluating the current signal thus measured and determining therefrom a central relative position of the beam with respect to an optimal position predefined on the beam calibration device surface.

Furthermore, advantageously the central relative position obtained in the last mentioned step may be used for deflecting the beam back to the designated target position using a reverse lateral deflection which includes an inverse of the initial deflection combined with a deflection correction, which deflection correction represents a correction of the lateral beam position to compensate the central relative position. This may, in particular, serve to compensate for drifts of the lateral position of the beam.

This method provides a efficacious approach for determining and/or implementing a calibration position of the beam, which also allows compensating of drifts within the charged-particle processing apparatus. Herein, "particles arriving (at the registering structure)" means that these particles hit the shape of the respective registering structure so as to contribute to the signal of measurement. As a typical special case, the charged particles may be electrons, and then the beam calibration device is configured to detect electrons. The method according to the invention can also be used for determining a "distortion" of the beam at the target position, where "distortion" refers to a variation of focal properties across the area of the beam (different beamlet constituting the beam), and thus can contribute to better detect the presence and amounts of imaging defects of the image field generated by the beam on the target.

The invention, in particular the method according to the invention, may also include in particular one or more of the following developments.

Advantageously, the evaluating step may include fitting an pre-selected function to the measured current signal, obtaining optimal fitting parameters from which to determine a center location of the signal curve (which represents the signal intensity as function of the position).

In many embodiments, the steps of deflecting the beam and performing a scan are realized by using a beam deflection device of the charged-particle processing apparatus (this beam deflection device is, typically, positioned upstream of the target plane) and wherein, in the step of performing a scan, the beam is deflected across the registering structure through a plurality of scanning positions in accordance with a predefined grid of positions. This grid may, preferably, have a grid pitch (mesh width) that is either smaller than the nominal size of a beamlet spot as produced by a single beamlet in the target plane (for instance, by a factor $1/2^n$ where n is an integer, or half-integer in the case of a double-centered grid raster as illustrated in Fig. 8C of US 10,651,010 of the applicant), or equal to the nominal size of such a beamlet spot. In other embodiments, the grid pitch may also be larger than the beamlet spot nominal size, for instance double size or a convenient multiple (such a factor $2^n$ where n is an integer, or half-integer in the case of a double-centered grid raster).

Furthermore, it may be advantageous, in particular in case the step of performing a scan is repeated, so as to have multiple instances of the scanning step, that, based on a predetermined (conceptual) partition of the grid of positions into a number of mutually distinct subsets, which represent sub-grids that preferably are substantially equivalent, in each instance of the step of performing a scan, one of these subsets is used; this means that the beam is deflected only through scanning positions corresponding to the respective subset (in one instance); and in case the scanning step is repeated, subsequent instances of the step of performing a scan use respectively different subsets, thus cycling through the number of subsets. Furthermore, the grid used for performing the scan may be composed of grid areas having different mesh widths, that is, at least two grid areas having different grid pitches; preferably, the grid areas having a larger grid pitch are defined in regions that are less significant for the quality of the determination of a central relative position.

The calibration method of the invention may suitably be performed during or immediately before a writing process on a substrate provided at the designated target position. This can ensure an enhanced precision of the respective writing process and avoids intervening disturbing contributions to drift.

The calibration method of the invention is of particular advantage for use a in a charged-particle optical apparatus realized as a multi-column system. Such a system will comprise a plurality of particle-optical columns configured for processing simultaneously on the same target, which is positioned in the target plane: advantageously a plurality of beam calibration devices may be provided, to be positioned longitudinally at or close to the plane of a target at a position lateral to the target and preferably separate from the target; for each of the beams, or each of a selected subset of the beams, that belong to a number of particle-optical columns (this number preferably corresponding to the number of beam calibration devices), the above-described method steps of deflecting the beam, performing a scan, and measuring an electric current caused by the beam will then be carried out using a respective one of the beam calibration devices.

Thus, a number of beams (particle-optical columns) can be simultaneously calibrated using a number of beam calibration devices.

A further advantageous development of the method may use a number of mutually different beam portions of the beam (each of these portions may be represented by one beamlet or a group of beamlets, where the groups of beamlets representing the beam portions are arranged according to preferably the same arrangement) are used for a corresponding number of calibrations, which are performed subsequently (preferably, but not necessarily immediately subsequently); then, the results of the respective central relative positions thus determined (from said number of calibrations) are used to deduce a distortion or distortion map, describing how different portions of the beam at the designated target position are positioned relative to each other. This may be used for determining a "distortion" of the beam at the target position, as already mentioned. In particular, for said number of calibrations performed subsequently using said mutually different beam portions, a plurality of registering structures are used, which are arranged at respective predetermined locations on the beam calibration device, wherein advantageously the registering structures are substantially aligned with locations of said mutually different beam portions as projected onto the registering structures. Herein, "substantially aligned" means that small deviations are allowed which do not impair the accuracy of the calibration measurements.

A further aspect of the invention is directed at a beam calibration device for calibrating a charged-particle beam in a charged-particle processing apparatus (in particular an electron beam in a processing apparatus employing such an electron beam), which device is in particular used during the method of the invention, wherein this device is configured / intended to be used in such apparatus employing a charged-particle beam (in particular electron beam) of a predetermined type, and the beam calibration device is configured to detect the particles of said specific type and comprises: a registering surface provided with at least one registering structure, oriented substantially perpendicular to an axis direction along which the beam is to be irradiated onto the beam calibration target; and a detector configured to measure the amount of charged particles (which typically may be electrons) arriving at the at least one registering structure as an output signal upon being irradiated by the beam (also here, "particles arriving at a registering structure" means that these particles hit the shape of the respective registering structure so as to contribute to the signal of measurement); the beam calibration device is configured to transmit the output signal to a calibration controller to which the beam calibration target is connectable, for having the output signal evaluated.

The devices of the invention may also include in particular one or more of the following developments.

Advantageously, the registering surface may be realized as a membrane, in particular a free-standing membrane, which is provided with at least one registering structure, where such a registering structure is transparent for the charged particles impinging on the registering surface and otherwise impermeable for the charged particles; and the detector is positioned downstream of the registering structure(s) and is configured to measure the amount of charged particles passing through the registering surface.

Furthermore, the registering surface may suitably be provided with a plurality of registering structures which may have different shapes or may have the same shape when viewed along the optical axis, i.e. the axis direction along which the beam is (to be) irradiated.

Furthermore, the invention also includes a charged-particle processing apparatus including at least one beam calibration device according to the invention; preferably the beam calibration device is positioned longitudinally at or close to the plane of a target in the processing apparatus and preferably at a lateral offset from a position intended for a target to be processed by the processing apparatus; in particular, one or more beam calibration devices may be disposed at a position external to the target. Herein, "close to" means that the device may be at a small distance to the relevant plane, which has no significant effect on the imaging properties with respect to the calibration procedure, and in particular that no optical component of the apparatus is between the device and the target plane, as seen along the longitudinal direction. The charged-particle processing apparatus may further include a calibration controller, to which the beam calibration device is connectable, and such calibration controller is suitably configured to receive a position signal relating to a relative position of the beam impinging on the beam calibration device and to record the output signal as a function of the relative position and determine therefrom an optimal relative position of the beam.

The charged-particle optical apparatus may also be realized as a multi-column system, which comprises a plurality of particle-optical columns, where each column comprises a respective beam calibration device according to the invention, respectively positioned longitudinally at or close to the plane of a target in the respective column, and preferably at a lateral offset from a target position in the respective column (laterally beside the target of the multi-column system), the multi-column system preferably comprising a calibration controller connected to the beam calibration devices, provided for calibrating charged-particle beams of the particle-optical columns, and advantageously using the respective output signal provided by the respective beam calibration devices and respective position signals relating to relative positions of the respective beams impinging on the respectively corresponding beam calibration devices. In such a system with multiple beam calibration devices, all beam calibration devices may be arranged in a fixed arrangement, or each of them may be mounted on a respective moveable stage, in order to allow for correction of misalignments between the beam calibration devices according to the arrangement of the single columns. The plurality of beam calibration devices may, preferably, be positioned not only longitudinally at or close to the plane of the target, but also at a position lateral to the target and, possibly and advantageously, separate from it. Furthermore, the plurality of particle-optical columns may preferably be configured for processing simultaneously on the same target, and in this case each of said plurality of beam calibration devices may suitably be associated with a respective one of said plurality of particle-optical columns or with a respective one of several mutually disjunct groups of particle-optical columns, and is used for performing the calibration for the respectively associated one of these columns (or, respectively, one of the columns of the respectively associated group).

Brief description of the drawings

In the following, in order to further demonstrate the present invention, illustrative and non-restrictive embodiments are discussed, as shown in the drawings, which show:

| | |
|---|---|
| Fig. 1 | a charged-particle multi-beam system in a longitudinal sectional view; |
| Fig. 2 | a pattern definition system of state of the art in a longitudinal section; |
| Fig. 3 | shows the layout of a BCT according to an embodiment of the invention, namely, a longitudinal sectional view in Fig. 3A, a top view in Fig. 3B; |
| Fig. 4 | shows a top view of the BCT of Fig. 3 with a beam image projected on the BCT during a scan; |
| Fig. 5 | show a few examples of suitable shapes of registering structures, in particular, a cross (Fig. 5A), an L-shape (Fig. 5B), a rectangle or square (Fig. 5C), and a box shape (Fig. 5D); |
| Fig. 6 | illustrates an example of a one-dimensional signal produced with a slit-shaped registering structure; |
| Fig. 7 | illustrates a signal profile produced with a cross-shaped registering structure and a point-like beam; |
| Figs. 8A and 8B | illustrate signal profiles produced with a cross-shaped registering structure and a beam of cross-shape of two different sizes; |
| Fig. 9 | depicts a registering structure in a top view, where due to ageing, material has deposited at the inward longitudinal edges of the structure; |
| Fig. 10 | depicts a dense grid of grid points used during a calibration scan; |
| Fig. 11 | illustrates the overlap of two beam spots in interlocking grids; |
| Figs. 12A and 12B | show a one-dimensional and a two-dimensional example of grids comprising "thinned-out" gird areas; |
| Fig. 13 | shows the deflection vectors of a calibration procedure on a BCT and a target; |
| Fig. 14A | shows an exemplary layout of a BCT (top view) having an array of registering structures; |
| Fig. 14B | shows a beam cross-section of a beam corresponding with the BCT of Fig. 14A; |
| Figs. 15A and 15B | show a multi-column writer tool including BCTs, where Fig. 15A shows a schematic longitudinal section of the writer tool, and Fig. 15B shows a detail view of a BCT in the writer tool of Fig. 15A; AND |
| Fig. 16 | shows a detail view of a multiple BCT arrangement where each BCT is mounted in a movable stage within a common frame. |

Detailed description of embodiments of the invention

The detailed discussion of exemplary embodiments of the invention given below discloses the basic ideas, implementation, and further advantageous developments of the invention. It will be evident to the person skilled in the art to freely combine several or all of the embodiments discussed here as deemed suitable for a specific application of the invention. Throughout this disclosure, terms like "advantageous", "exemplary", "typical", "preferably" or "preferred" indicate elements or dimensions which are particularly suitable -but not essential- to the invention or an embodiment thereof, and may be modified wherever deemed suitable by the skilled person, except where expressly required. It will be appreciated that the invention is not restricted to the exemplary embodiments discussed in the following, which are given for illustrative purpose and merely present suitable implementations of the invention. Within this disclosure, terms relating to a vertical direction, such as "upper" or "down", are to be understood with regard to the direction of the particle-beam traversing the electromagnetic lens, which is thought to run downwards ("vertically") along a central axis (or longitudinal axis). This longitudinal axis is generally identified with the Z direction, to which the X and Y directions are transversal.

Electron optical system

In a favorable embodiment of this invention, the beam calibration method is applied in a multibeam writer tool as illustrated in Fig. 1 in order to calibrate the transversal positioning of a shaped charged-particle (electron) beam on the image plane with respect to a reference point, which can, in particular, be used for proper positioning of the beam on a mask substrate loaded into the apparatus at the desired target position. The method preferably uses the following device components:

- an electron optical system 5 of the writer tool that is able to define a beam or an ensemble of beams with a pattern definition device 4;
- a beam calibration target 19 (BCT), placed in the target plane of the electron optical system and including an electron current measuring device, and configured to generate an output signal $s_1$ whose intensity describes to what extend the beam is irradiating structures on the BCT;
- an electron optical deflection device 12c of the writer tool that can deflect a group of electron beams across the target plane, and which is usually placed immediately (i.e., as the last particle-optical component) in front of the target plane with respect to the beam path.

The mentioned components are controlled by the controller 56 of the writing apparatus 1. The beam calibration process according to the invention uses the signal $s_1$ generated by the BCT 19 and a signal $s_2$ which specifies the relative position of the beam as it impinges on the target plane, such as a signal branched-off from the deflection signal that controls the deflection device (symbolized by a wavy line in Fig. 1). Suitably, the beam calibration will be performed in a program module of the controller 56 or in a specific calibration controller 59, which cooperates with the controller 56 and may, preferably, be located within the housing 2 of the writing apparatus 1.

Beam calibration target (BCT)

The BCT serves to register the coincidence of a beam with a pre-defined nominal position on the BCT top surface. The BCT will be realized as a component mounted to the mask chuck 15 holding a substrate 16 (or other target) and/or the target stage 14. This allows that the BCT is placed to a side of the location of a substrate 16. With respect to the longitudinal direction the BCT is arranged such that its top surface is positioned in the target plane of the electron optical system. The BCT top surface will suitably comprise a registering surface oriented towards the incoming beam as described below.

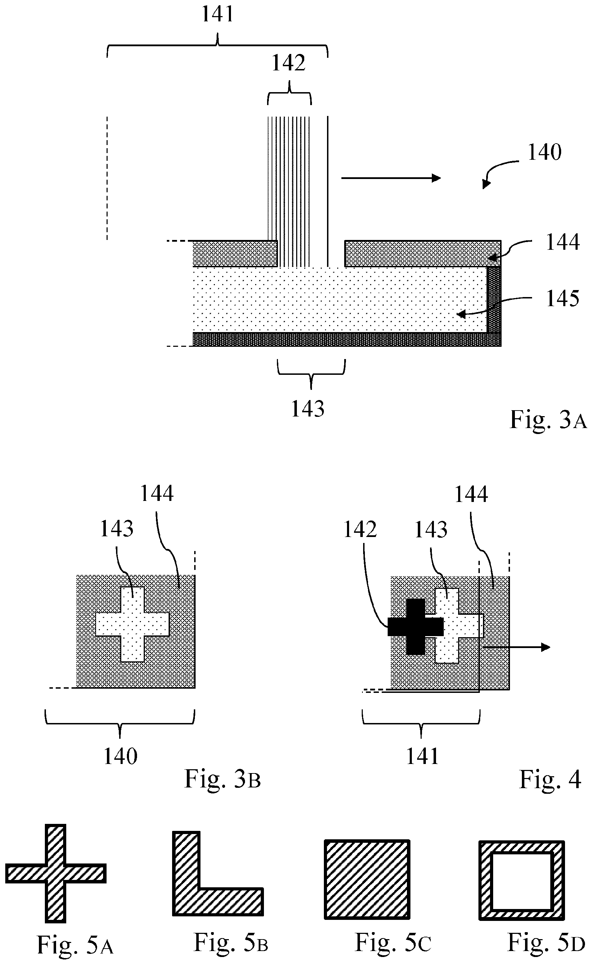

One suitable embodiment of a BCT is illustrated in Fig. 3. The BCT 140 comprises a registering surface, for instance a structured top membrane 144, which has a number of registering structures (such as an aperture 143 formed in the membrane 144, or a plurality of such apertures arranged in a specific two-dimensional layout) as well as an electron current measuring device 145, placed below the registering surface (or membrane).

Each registering structure is preferably realized as a recess and/or hole formed in the surface of the BCT 19, for instance as an aperture in the top membrane of the BCT. In the embodiment shown in Figs. 3A and 3B, the registering structure is an aperture 143 allowing passage of electrons, whereas the other regions of the membrane 144 will block (by absorbing and/or reflecting) any incoming electrons. In other embodiments, a registering structure may be formed as a shaped recess, thus thinning the membrane in the recess to a thickness which allows the energetic electrons to penetrate, while the other regions of the membrane have a considerably higher thickness (and preferably an additional covering layer as discussed below) so the electrons cannot pass the membrane in the latter regions. The shape of a registering structure, as seen in a top view on the BCT surface, may be any suitable shape, such as a narrow rectangle (i.e., slit), an L-shape (Fig. 5B), a rectangle or square (Fig. 5C), a box shape (Fig. 5D), or a cross (Fig. 5A, 3B)

Calibration procedure

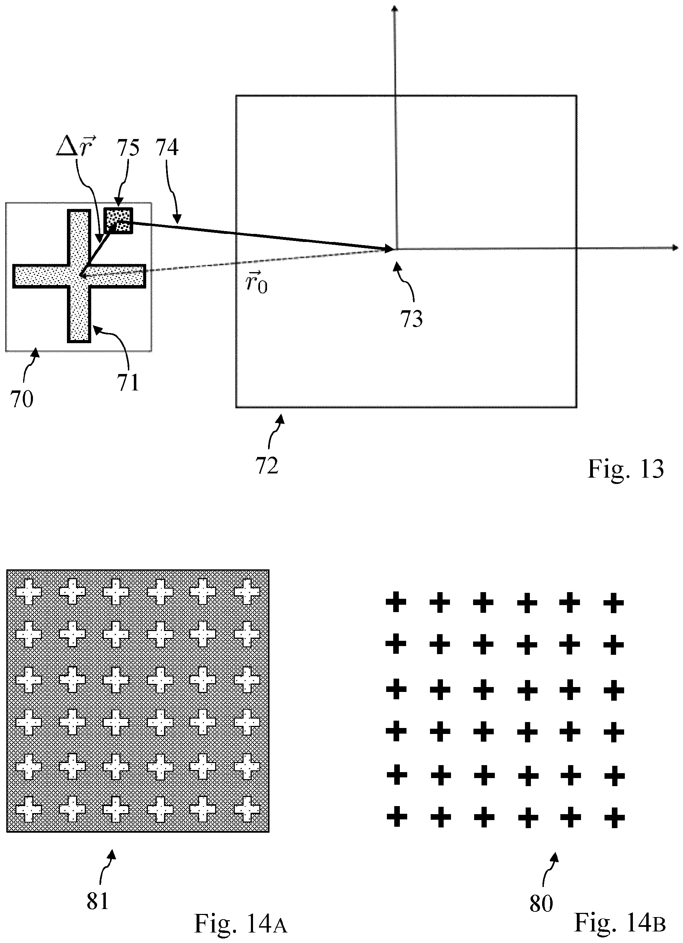

In an exemplary embodiment of the invention, and referring to Fig. 13, a preferred process of lateral position calibration comprises the following steps:

- generating an electron beam realized as a single beamlet or multiple beamlets, within the charged-particle multi-beam writer tool using the PD device to define said beamlet(s) according to a specific beam pattern (as discussed further below);
- deflecting the electron beam by a suitable "initial deflection" $\vec{r}_0$ towards a BCT 70 and, preferably, a specific registering structure 71 of the BCT (as discussed further below), where the "initial deflection" corresponds to a (previously measured or calculated) relative position of the BCT with respect to a predefined target reference position 73 ("designated target position") on a target 72; this deflection is preferably achieved by means of a deflection device of the writer tool, usually a multipole deflector, such as the deflection device 12c of the multi-beam system of Fig. 1, and additionally a movement generated by the substrate stage 14 may be included, in particular in the case of a large initial deflection;

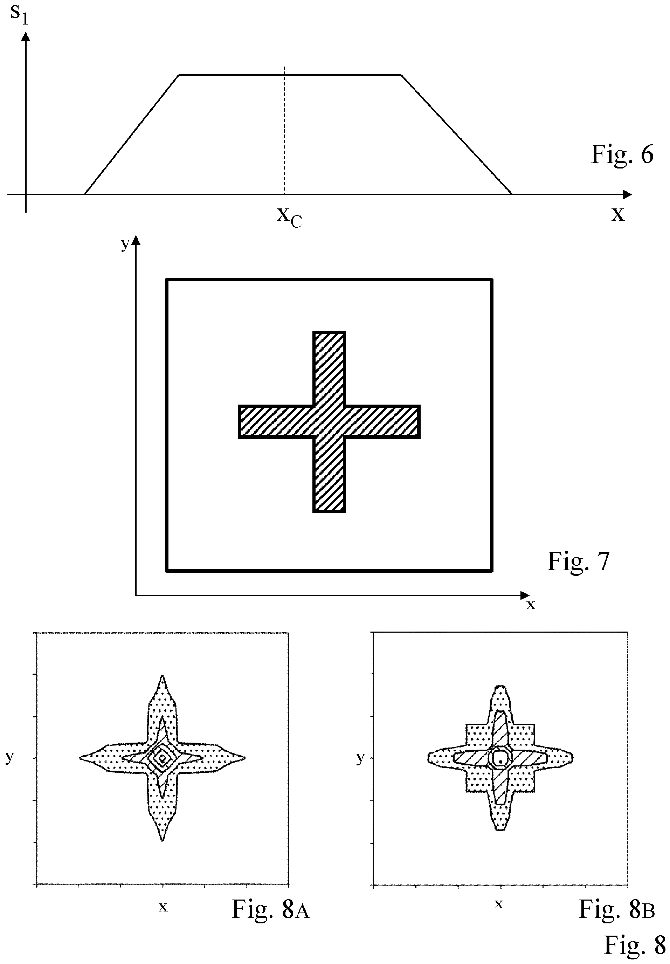

- allowing the electron beam 75 to illuminate the BCT 70 within a range close to the specific registering structure(s) 71;
- performing a scan using the mentioned deflection device to deflect the beam according to a grid of positions across the registering structure, wherein the scan is suitably performed over an area large enough to ensure that the scan will cover the registering structures, and preferably the scan is made using a set of discrete scanning grid positions according to a predefined grid (see below for a discussion of suitable grids);
- measuring the electron current able to pass the BCT registering structures using the electron current measuring device, exploiting the fact that the measured current signal $s_1$ will, as a function of the grid point position of the scan, form a curve, which corresponds to the convolution of the electron beam and the registering structure (see Figs. 6 to 8B),
- fitting an appropriate function to the measured current signal to determine a center location ($x_C$ in Fig. 6) of the signal curve $s_1$;
- determining, from the center location thus determined, the deviation of the electron beam 75 from a desired (nominal) position on the BCT $\vec{\Delta r}$ (this deviation is also referred to as "central relative position"), which in turn can be used to determine a deflection correction that is needed to reposition (or center) the electron beam with respect to the registering structure; and
- deflect the electron beam back by a suitable reverse deflection 74 from the BCT to the designated target position 73, using the mentioned deflection device, where the reverse deflection 74 includes a basic reverse deflection $-\vec{r}_0$ (which corresponds to an inverse of the "initial deflection") and also the deflection correction determined in the previous step $-\vec{\Delta r}$.

Thus, the electron beam is repositioned as needed to correctly place the electron beam on the target 72 at a specific target position as required for a subsequent writing process on a substrate provided in the target position.

The calibration process is controlled by a calibration controller 59 that controls the mask stage position as well as the deflection device (for instance by controlling the supply voltages of the latter). This is advantageous in view of the inventors' observation that, typically, the positioning accuracy of the target stage is inferior to, and often even significantly worse than, that of the optical deflection element. Therefore, the stage is moved approximately so that the electron beam is able to hit the BCT and the deflection device is used for the fine positioning of the beam position on the target and to perform the scanning steps as needed during the writing process. To perform a desired spatial deflection, the method may also involve using a sensitivity matrix that indicates the required voltages supplied to the deflection device. This will be discussed in more detail further below.

The calibration controller 59 may be realized as a program module of the controller 56, or as a specific controller device which cooperates with the controller 56 and may, preferably, be located within the housing 2 of the writing apparatus 1. For the beam calibration process according to the invention, the calibration controller 59 uses the signal $s_1$ generated by the BCT 19 and a signal $s_2$ which specifies the relative position of the beam as it impinges on the target plane (symbolized by a wavy line in Fig. 1, as in general this signal $s_2$ may be a control signal of the deflection device 12c or a signal branched-off from the deflection device control signal).

Patterns of the BCT registering structures

In an exemplary embodiment of the invention, the scan is performed for a beam, as formed in the PD device, defined by a single beamlet. The beam traverses the electron optical system of the writer tool for performing a lateral position calibration according to the invention. It will be appreciated that, if the size of the single beamlet is small compared to the typical dimensions of the registering structure of the BCT, the resulting measured current signal scan will produce a map which will generally look like the form of the structure itself (since the convolution of a point-like function with a specific shape simplifies to the very equal shape). In the exemplary case that the shape of a registering structure is a cross (Fig. 3B), the measured current pattern as a function of the transversal coordinates x and y will reproduce this shape as shown in Fig. 7, if the transversal size of the beam is negligible as compared to the feature size of the cross.

Due to the non-zero (finite) size of a typical electron beamlet formed by the pattern definition device, there will be transition zones at the borders of a BCT pattern in the current measurement, illustrated in Fig. 6, which shows the intensity produced by a simple slit-shape structure when traversing perpendicular to the direction of extension of the slit shape (one-dimensional signal). Since a real electron beamlet formed by the pattern definition device has a non-zero blur, the resulting signal will additionally have blurred out corners (rather than linear flanks as shown in Fig. 6).

Using a single beamlet for the calibration may incur the disadvantage of a low signal-to-noise ratio in the current measurement. This strongly depends on the method of current measurement, as discussed in more detail below. Using a beam comprising multiple beamlets can alleviate this problem. Furthermore, when multiple beamlets are used to perform the calibration, this offers the additional advantage that the beam may have suitable pattern structure.

Fig. 3A shows a longitudinal sectional detail view of a BCT 140 at one aperture 144 thereof, and Fig. 3B shows a top view of the BCT aperture. In addition, Fig. 4 illustrates a scan using a shaped beam 142 composed of multiple beamlets, where the beam (more exactly the image of the beam, shown as a dark-shaded cross in the drawing) scans across the registering structure 143 along the direction indicated by an arrow. Depending on the position of the beam with respect to the registering structure only some of the beamlets are transmitted through the membrane 144 towards the current measuring device 145. For an exemplary pattern of beamlets, arranged in a cross, and an aperture in the BCT membrane also of cross form, the measured current pattern in two dimensions will typically look like shown in Figs. 8A and 8B.

Fig. 8A shows an example where the cross-shaped electron beam pattern has exactly the same size as the BCT pattern, whereas in Fig. 8B, the cross-shaped electron beam pattern is smaller.

As can be seen in the drawings, the current patterns of Figs. 8A and 8B include considerable transition zones, which are created due to the partial transmission of the group of beamlets at the edges of the aperture. The calibration result includes the average deflection of the beamlets.

In general, it is not required that the pattern of the beamlets be similar to the shape of the apertures (or more generally, registering structures).

## Charged particle current measurement

The BCT also comprises a device for accurately measuring the electron current transmitted through the BCT registering structures; preferably this measuring device should have high precision and a large signal-to-noise ratio. In an exemplary embodiment of this invention, the measuring device may be a Faraday cup located downstream of the membrane containing the registering structures. In other embodiments, other suitable types of devices may be used, such as a channeltron or a semiconductor detector.

## Material choices for the BCT

The choice of material for the BCT may affect its performance. The highest priority for the BCT functionality is the opacity for electrons at regions different from the registering structures, which can be optimized by choosing an adequate thickness of the material. In one exemplary embodiment, the bulk material may be silicon coated with a metal, such as titanium. Silicon has the advantage of being well processible (exploiting paramount experience in the processing industry), which strongly facilitates creating the registering structures. A coating, for example titanium coating, is advantageous for protecting the silicon from oxidation. Furthermore, an electrically conductive coating helps to prevent the BCT surface from charging up during electron exposure. Furthermore, it is advantageous that the coating is vacuum-compatible. The skilled person will appreciate that the choice of material also has an impact on the backscattering of electrons generated on the BCT surface, which may influence other parts of the writer tool.

## Aging - deposition of material on the registering structures

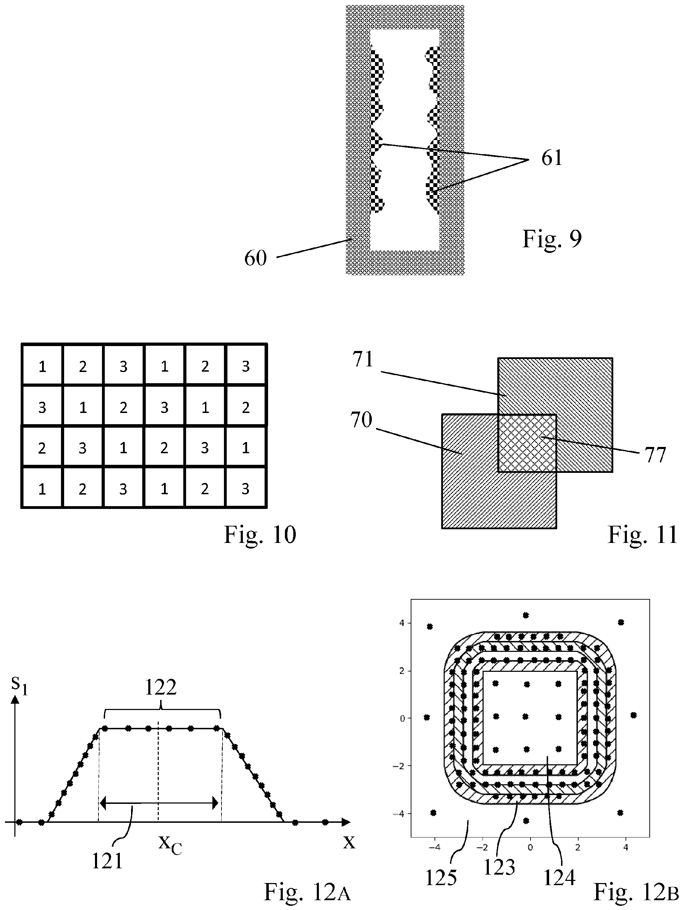

Due to electron interaction with residual gas and other effects, material (for example carbon compounds) may be deposited in or at the border of the registering structures, further called aging. In particular, the recesses or openings may grow closed. In general, this aging may be inhomogeneous along the edges of the registering structures due to the exposure positioning of the beamlets. An example of aging is illustrated in Fig. 9, which depicts a slit-shaped registering structure 60 from above, where material of irregular shape 61 has deposited at the inward longitudinal edges. This aging will disturb the current measurement and consequently the center position determined using the "aged" registering structure, up until that a measurement becomes unreliable. By choosing the calibration scan grid positions in a particular way, the aging can be reduced and homogenized so as to reduce or even rule out the problem, as discussed in the following sections.

## Calibration scan strategies

The choice of grid positions that are used during a calibration scan may strongly influence the performance of the calibration as well as the above-mentioned aging effect. On the one hand, a higher number of grid points provides finer data to be fitted, improving the fit quality, but on the other hand, the scan takes longer. The aging effect depends on the placement of the beamlets along the edges of the registering structure. One possible improvement is to define a dense grid as illustrated in Fig. 10, so that the deposited electron beam dose over all scan points is homogeneous. In Fig. 10 each of the squares correspond to one beam spot as produced by the beam during the scan, and the entire area is thus completely covered by the beam spots of the grid as also shown in Fig. 10 ("dense grid").

To reduce the total number of grid points used during each one of the calibration processes, only a sub-grid of the grid may be used, and when the calibration process is performed multiple times, different sub-grids of the same grid are used; this is also referred to as "spreading out" the grid over multiple calibrations. For instance, still referring to Fig. 10, in one loop of the calibration process, only the beam spots numbered as "1" are used, in a next loop of the calibration, the beam spots numbered "2", in a third loop the beam spots numbered "3", and then "1" is used again and so on. Thus, the entire dense grid is used by a subsequent set of multiple calibrations (in this example, three calibrations). This allows to reduce the number of grid points used during an individual instance of the calibration process, thus reducing the time used by the scan and the complexity of calculation.

Overlapping beam spots, Interlocking grids

In another suitable development of the invention, and in addition to the dense grid mentioned above, it is possible to further counteract aging by using overlapping beam spots, for instance in the context of so-called "interlocking grids". Herein, interlocking grids are multiple grids which are positioned interlacing by mutual offsets which are only fractions of a grid spacing (which corresponds to the nominal size of a beamlet spot on the target), which enables creating sub-pixels by allowing the beamlet spots to overlap (for example by 25 or 50 percent of one pixel on the target), thus creating sub-pixels in the pattern raster generated by the beamlets. Interlocking grids are described in US 7,276,714 and US 9,053,906 of the applicant in more detail. An simple example of overlapping beam spots is shown in Fig. 11, where a pixel 70 formed by a first beamlet is overlapping with another pixel 71, and the overlapping region forms a sub-pixel 77, to which the combined dose from the two pixels 70 and 71 is deposited. The interlocking grid may also be "spread out" over multiple calibrations. This has the advantage of further homogenizing the electron beam dose that is applied to the edges of the registering structure, because local inhomogeneities of beamlets will average out to considerable extent.

Thinning out of the scan grid

In the scan grids as used in the above-mentioned scan strategies, which primarily focus on homogenizing aging, there are regions in the grid, that do not influence the aging and are less significant or possibly even insignificant for the subsequent fit quality. Such regions may be scanned using a reduced number of grid points; thus, these regions are covered by a grid area where the grid is "thinned out", in that the grid pitch (in such a grid area corresponding to less significant regions for the fit to determine the central relative position) is larger than in a grid area that corresponds to regions that are (more) significant for achieving a good quality of the fit (i.e., generally, more important for the determination of a central relative position).
Figs. 12A and 12B illustrate examples of "thinned-out" scan grids. Fig. 12a illustrates an example of a linear scan where the beam pattern illuminates a registering structure that is larger than the beam pattern. In this case, there is a central region 121 in the scan where the full beam passes through the structure, and the grid points in this region 121 have negligible impact on the aging. Thus the grid points falling in the region 121 have little significance for the fit quality. To reduce the time needed for a scan, grid points in such a region can be thinned out. Such a thinning is depicted in Fig. 12A, where the grid points in a one dimensional scan example are thinned out in a grid area 122, which is located within the expected range of a plateau. Fig. 12B illustrates a two-dimensional example for a square-shaped registering structure. In this example, only the ring-shaped region 123 that is expected to coincide with the locations where a change of signal will occur, is implemented using a grid of small grid pitch, whereas other regions 124, 125, which in the case illustrated in Fig. 12b are inside and outside the region 123, respectively, are "thinned out".

Deflection device

The deflection device is used to perform precise deflections for a scan. The deflection device is, e.g., a electrostatic multi-pole electrode system, allowing realizing a deflection by applying electrical potentials to the individual electrodes. In its most simple form, the deflection element is a plate capacitor. To deflect in two perpendicular directions, a double plate capacitor may be implemented. Advantageously, the deflection device is a multi-pole system having a suitable number of electrodes. A preliminary calibration procedure may be used to measure the deflection sensitivity of the deflection element, i.e. which voltage $V_1$, $V_2$ is needed to perform a specific transversal deflection of beamlets, where the transversal deflection is described as a vector ($dx$, $dy$). The deflection sensitivity may be expressed in a sensitivity matrix $s_{ij}$, indicated by the following equation

$$\begin{pmatrix} dx \\ dy \end{pmatrix} = \begin{pmatrix} s_{1x} & s_{2x} \\ s_{1y} & s_{2y} \end{pmatrix} \cdot \begin{pmatrix} V_1 \\ V_2 \end{pmatrix}$$

The components of this sensitivity matrix can be measured in the mentioned preliminary calibration procedure.

Using the sensitivity matrix enables a suitable approach for controlling predefined deflections, such as $\vec{r}_0$ or $\vec{\Delta r}$ in Fig. 13.

Fit procedure

The fit procedure is one step in the calibration process according to the invention, and serves to determine a potential spatial transversal offset such as the offset vector $\vec{\Delta r}$ (see Fig. 13) between the expected position of the beam center and the actual beam center positioned as measured one. Evidently, the function used for the fit is selected suitably so as to describe the general form of the convoluted measured electron current pattern with sufficient accuracy. Suitably the fit procedure will include a translation, described by an offset in the two transversal coordinates x and y. The accuracy of the fitted offsets is determined by the quality of the fit function, the grid points (number and placement) as well as potential noise on the measured current signal. A determined non-zero offset indicates a deflection correction in the optical system (e.g. caused by a drift over time). Therefore, measuring the offset can be used to re-calibrate the overall electron beam to a central position. One example of a fit function, that may be used for the one dimensional example in Fig. 6, is a trapezoid function realized with a piecewise definition:

$$
f(x) = \begin{cases}
0, & x < x_0 - \dfrac{l}{2} \\[2mm]
\dfrac{2(B-A)}{p-l}x + A - \dfrac{2(B-A)}{p-l}\left(x_0 - \dfrac{p}{2}\right), & x_0 - \dfrac{l}{2} < x < x_0 - \dfrac{p}{2} \\[2mm]
A, & x_0 - \dfrac{p}{2} < x < x_0 + \dfrac{p}{2} \\[2mm]
\dfrac{-2(B-A)}{p-l}x + B + \dfrac{2(B-A)}{p-l}\left(x_0 + \dfrac{l}{2}\right), & x_0 + \dfrac{l}{2} > x > x_0 + \dfrac{p}{2} \\[2mm]
0, & x > x_0 + \dfrac{l}{2}
\end{cases}
$$

with a base level B, its length *l,* a plateau level *A*, its length p as well as a center $x_0$. Another example is a fit function having curved flanks, which can be modelled by stitching together suitable functions such as a first sigmoid function for a raising flank and a second sigmoide function for a falling flank. Suitable fit functions for two-dimensional fits or higher can be provided readily by the skilled person by stitching suitable one-dimensional functions.

Measuring a distortion of beamlets

Referring to Figs. 14A and 14B, using different beamlet sections of the image field, a distortion measurement can be performed, i.e. how different segments of beamlets of the full image-field are positioned relative to each other or relative to ideal positions. For this, preferably, multiple registering structures may be used. For instance, as shown in Fig. 14A, a complex BCT having an array of 6 by 6 registering structures 81, which preferably may have the same shape, but may also have different shapes, is used, in conjunction with a beam 80 as shown in Fig. 14B that has a suitable shape, and in particular may be preferably composed of a corresponding array of sub-beams.

Multi-Column System

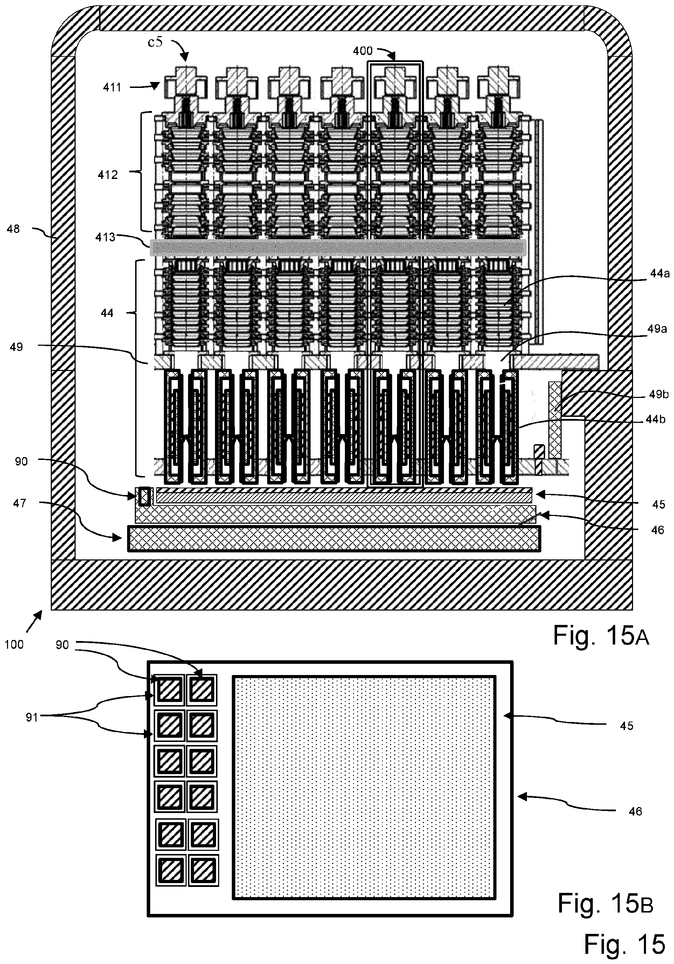

Figs. 15$_A$ and 15$_B$ illustrate a multi-column writer tool 100. The writer tool employs a number of charged particle beams, which may be of electrons or ions (for instance ions of positive electric charge). As can be seen in Fig. 15$_A$, which shows a schematic longitudinal sectional view of the multi-column writer tool 100, the writer tool 100 comprises a vacuum housing 48 for the multi-column charged particle optics, a base 47 onto which the multi-column charged particle optics is mounted. On top of the base an X-Y stage 46, e.g. a laser-interferometer controlled air-bearing vacuum stage onto which a target 45, preferably an mask for lithographic purposes or silicon wafer in direct-writer tools, is mounted using a suitable handling system. The target may then be exposed with said charged particle beam of the writer, which e.g. comprise an resist layer. The multi-column writer tool 100 further includes, preferably for each column or each of a subset of the columns, a respective instance of a BCT 90 according to an embodiment of the invention. The respective BCTs 90 (symbolically depicted as hatched squares in Fig. 15B) may be placed on the stage 46 beside the target 45.

The multi-column optics of this embodiment comprises a plurality of sub-columns 400 (the number of columns shown is reduced in the depiction for better clarity, and represent a much larger number of columns that are present in the multi-column apparatus in a realistic implementation). Preferably, the sub-columns have identical setups and are installed side-by-side with mutually parallel axes c5. Each sub-column has an illuminating system 412 including a charged particle source 411, delivering a broad telecentric charged-particle beam to a pattern definition system 413 being adapted to let pass the beam only through a plurality of apertures defining the shape of sub-beams ("beamlets") permeating said apertures (beam shaping device), and a typically demagnifying and further energizing charged particle projection optics 44, composed of a number of consecutive charged particle lenses, which preferably include electrostatic and/or magnetic lenses, and possibly other particle-optical devices. In the embodiment of Fig. 15, the projection optics comprises e.g. a first charged particle lens 44a, e.g. an electrostatic immersion lens, whereas a second lens 44b, located downstream of the first lens, may be realized using an charged particle electromagnetic lens.

Fig. 15B shows, in a detail top view, the lower portion of the multi-column writer tool 40 where multiple BCT devices 90 are located on the stage besides the target. Each BCT is positioned longitudinally at or close to the plane of a target. A common calibration controller (not shown; cf. controller 59 in Fig. 1) is provided which performs and controls the calibration procedures of the charged-particle beams of the particle-optical columns. In particular, if there is a BCT for each column and the BCT devices are arranged corresponding to the lateral positions of the columns, the calibration procedure may be done simultaneously for all of the columns; or if there is not a BCT for each column, a suitable subset of the columns can be calibrated simultaneously and the other columns in subsequent steps. For effecting the initial deflection of the beam(s) of respective columns towards the BCTs 90 as well as the reverse deflection back to the exposure area on the substrate, the target stage 46 cooperates with a multipole deflector component of e.g. the final lens 44b of the respective columns to generate a suitable total deflection of the beam between the target position and the position of the respective BCT 90.

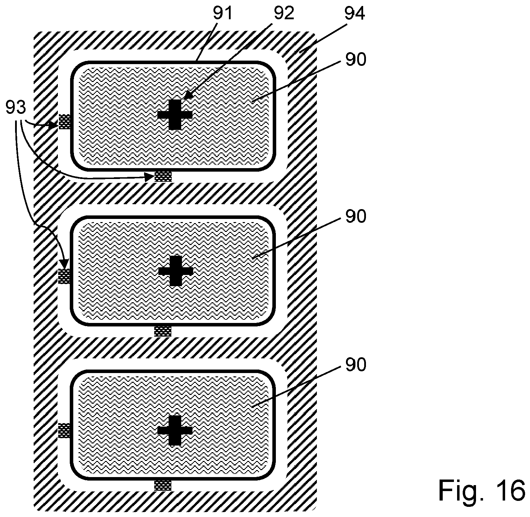

The grid of BCT devices 90 and the grid of columns in a multi-column system may not be perfectly aligned in the plane transversal to the beam. Therefore, in another exemplary multi-column embodiment of this invention, the multiple BCT devices are mounted on a moveable stage 91 each, so that the BCT placement can be corrected to match the grid arrangement of the columns. Fig. 16 shows a detail view of the multi-column embodiment of this kind, showing three BCTs 90 (out of a larger number of BCT devices). Each of the BCTs 90 includes one registering structure 92 on a moveable stage 91 ensuring that each BCT can be adjusted in the plane transversal to the beam with the help of piezo elements 93 that are connected to a common frame 94 of the BCT devices.

## Claims

1. A method for calibrating a charged-particle beam in a charged-particle processing apparatus in relation to a positioning of said beam with respect to a target plane of said processing apparatus, comprising the steps of

   providing a beam calibration device, which includes a detector for said charged particles impinging on the device and arriving at at least one registering structure provided in a surface of said device, and positioning said beam calibration device to have said surface substantially in the target plane of said processing apparatus;
   generating a beam of said charged particles in said processing apparatus, said beam having a predefined shape, and imaging said beam to the target plane at a designated target position;
   deflecting the beam from the designated target position to the beam calibration device, by means of a predefined lateral initial deflection, said lateral deflection being transversal to the beam direction, thus allowing the beam to impinge on at least one of the registering structure(s);
   performing a scan of the beam on the beam calibration device, thus covering a pre-defined region on said device which includes said at least one registering structure;
   measuring, using the detector, an electric current caused by the beam during the scan, to obtain a current signal as a function of the position in said region;
   evaluating the current signal thus measured and determining therefrom a central relative position of the beam with respect to an optimal position predefined on the beam calibration device surface.

2. The method of any one of the preceding claims, employed in a charged-particle optical apparatus realized as a multi-column system that comprises a plurality of particle-optical columns configured for processing simultaneously on the same target, said target being positioned in said target plane,
   wherein a plurality of beam calibration devices are provided and positioned longitudinally at or close to the plane of a target at a position lateral to the target and preferably separate from the target, wherein for each beam of a number of the particle-optical columns, and with respect to a respectively associated one beam calibration device of the plurality of the beam calibration devices, the method steps of deflecting the beam, performing a scan, and measuring an electric current caused by the beam are carried out using the respectively associated beam calibration device.

3. The method of claim 1, wherein the beam is composed of a multitude of beamlets and wherein, in the step of performing a scan, the beam is, preferably using a beam deflection device of the charged-particle processing apparatus, deflected across the registering structure through a plurality of scanning positions in accordance with a predefined grid of positions, and wherein said grid has a grid pitch smaller than the nominal size of a beamlet spot as produced by a single beamlet in the target plane.

4. The method of claim 3, wherein based on a predetermined partition of said grid of positions into a number of mutually distinct subsets representing sub-grids that preferably are substantially equivalent, in the step of performing a scan, one of said subsets is used, thus the beam is deflected only through scanning positions corresponding to said subset, and in case the step of performing a scan is repeated in subsequent instances of said step, subsequent instances of the step of performing a scan use respectively different subsets, cycling through said number of subsets.

5. The method of claim 3 or 4, wherein said grid is composed of at least two grid areas having different grid pitches, wherein grid areas having a larger grid pitch are defined in regions that are less significant for the quality of the determination of a central relative position.

6. The method of any one of the preceding claims, wherein a number of mutually different beam portions of the beam are used for a corresponding number of calibrations performed subsequently, and the results of the respective central relative positions thus determined from the number of calibrations are used to deduce a distortion map, said distortion map describing how different portions of the beam at the designated target position are positioned relative to each other.

7. The method of claim 6, wherein for said number of calibrations performed subsequently using said mutually different beam portions, a plurality of registering structures are used, which are arranged at respective predetermined locations on the beam calibration device, wherein the registering structures substantially align with locations of said mutually different beam portions as projected onto the registering structures.

8. The method of any one of the preceding claims, being performed during or immediately before a writing process on a substrate provided at the designated target position.

9. A beam calibration device for calibrating a charged-particle beam of a predetermined type, said beam calibration device intended to be used in a charged-particle processing apparatus employing a charged-particle beam of said predetermined type,

   comprising:

   a registering surface (144) provided with at least one registering structure (143), said registering surface being oriented substantially perpendicular to an axis direction along which said beam is to be irradiated onto the beam calibration device; and
   a detector (145) configured to measure the amount of charged particles arriving at the at least one registering structure as an output signal ($s_1$) upon being irradiated by said beam;

   said beam calibration device being configured to transmit the output signal ($s_1$) to a calibration controller (59) to which the beam calibration device is connectable, for having the output signal evaluated.

10. The beam calibration device of claim 9, wherein the registering surface is realized as a free-standing membrane (144) provided with at least one registering structure (143), said registering structure being transparent for said charged particles impinging on the registering surface and otherwise impermeable for said charged particles, and wherein said detector (145) is positioned downstream of said at least one registering structure and is configured to measure the amount of charged particles passing through the registering surface.

11. The beam calibration device of claim 9 or 10, wherein the registering surface is provided with a plurality of registering structures which have the same shape when viewed along said axis direction.

12. The method of any one of claims 1 to 8, wherein the beam calibration device is realized as a beam calibration device as claimed in any one of claims 9 to 11.

13. A charged-particle optical apparatus realized as a multi-column system comprising a plurality of particle-optical columns configured for processing simultaneously on the same target positioned at a target plane within said apparatus, and further comprising a plurality of beam calibration devices according to any one of claims 9 to 11 respectively positioned longitudinally at or close to the plane of a target at a position lateral to the target and preferably separate from the target, wherein each of said plurality of beam calibration devices is associated with a respective one of said plurality of particle-optical columns or with a respective one of several mutually disjunct groups of particle-optical columns, the multi-column system preferably comprising a calibration controller connected to the beam calibration devices and provided for calibrating charged-particle beams of the particle-optical columns.

14. The charged-particle optical apparatus of claim 13, wherein each of the beam calibration devices (90) is mounted on a respective moveable stage (91).

15. A charged-particle processing apparatus including a beam calibration device according to any one of claims 9 to 11, said beam calibration device being positioned longitudinally at or close to the plane of a target in said processing apparatus and at a lateral offset from a position intended for a target to be processed by said processing apparatus, and further including a calibration controller (59), to which said beam calibration device is connectable, wherein the calibration controller is configured to receive a position signal ($s_2$) relating to a relative position of said beam impinging on the beam calibration device and to record the output signal ($s_1$) as a function of the relative position and determine therefrom an optimal relative position of the beam.

Fig. 1

Fig. 2 (prior art)

141

142

140

144

145

143

Fig. 3A

144

143

140

Fig. 3B

144

142  143

141

Fig. 4

Fig. 5A          Fig. 5B          Fig. 5C          Fig. 5D

Fig. 6

Fig. 7

Fig. 8A

Fig. 8B

Fig. 8

Fig. 9

Fig. 10

Fig. 11

Fig. 12A

Fig. 12B

$\Delta \vec{r}$   75   74

$\vec{r}_0$

73

70

71

72

Fig. 13

81

80

Fig. 14A

Fig. 14B

Fig. 15A

Fig. 15B

Fig. 15

Fig. 16

Europäisches Patentamt

European Patent Office

Office européen des brevets

## EUROPEAN SEARCH REPORT

Application Number

EP 24 16 2043

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 6 222 195 B1 (YAMADA AKIO [JP] ET AL) 24 April 2001 (2001-04-24)<br>* figs. 3, 57 to 68 and related text *<br>* column 8, line 65 - line 68 *<br>* column 10, line 17 - line 29 *<br>* column 38, line 6 - line 12 *<br>* column 38, line 20 - line 30 *<br>* column 39, line 52 - line 58 *<br>* column 41, line 40 - line 45 *<br>----- | 1,8,9,<br>12,15<br>14 | INV.<br>H01J37/304<br>H01J37/317 |
| A | WO 2022/192088 A1 (NIKON CORP [JP]) 15 September 2022 (2022-09-15)<br>* page 2, line 23 - line 27 *<br>* page 19, line 20 - line 25; claim 11 *<br>----- | 1 | |
| X<br>Y | US 2017/358425 A1 (IIZUKA OSAMU [JP]) 14 December 2017 (2017-12-14)<br>* figs. 1, 4, 6 to 9 and related text; paragraphs [0044], [0045], [0056], [0057] *<br>----- | 1,6-9,<br>12,15<br>3-5 | |
| X | JP H10 106931 A (HITACHI LTD) 24 April 1998 (1998-04-24)<br>* figs. 1 to 3 and related text; paragraphs [0012], [0022] - [0027] *<br>----- | 1,6-9,<br>11,12,15 | TECHNICAL FIELDS SEARCHED (IPC)<br>H01J |
| X<br>Y | US 2019/198290 A1 (INOUE HIDEO [JP]) 27 June 2019 (2019-06-27)<br>* figs. 1, 10 to 14 and related text; paragraphs [0051], [0071] *<br>----- | 9,11<br>3-5 | |
| X | US 2013/143161 A1 (ARITA KEIICHI [JP] ET AL) 6 June 2013 (2013-06-06)<br>* figs. 1 to 7, 9 and related text; paragraphs [0020], [0025] - [0027], [0041] *<br>----- | 1-15 | |

The present search report has been drawn up for all claims

| Place of search | Date of completion of the search | Examiner |
|---|---|---|
| Munich | 23 July 2024 | Krauss, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 2043

23-07-2024

| Patent document cited in search report | | Publication date | Patent family member(s) | | Publication date |
|---|---|---|---|---|---|
| US 6222195 | B1 | 24-04-2001 | KR | 970059839 A | 12-08-1997 |
| | | | TW | 343347 B | 21-10-1998 |
| | | | US | 5830612 A | 03-11-1998 |
| | | | US | 6137111 A | 24-10-2000 |
| | | | US | 6222195 B1 | 24-04-2001 |
| WO 2022192088 | A1 | 15-09-2022 | CN | 116964709 A | 27-10-2023 |
| | | | EP | 4305657 A1 | 17-01-2024 |
| | | | JP | 2024510603 A | 08-03-2024 |
| | | | US | 2024157641 A1 | 16-05-2024 |
| | | | WO | 2022192088 A1 | 15-09-2022 |
| US 2017358425 | A1 | 14-12-2017 | JP | 6808986 B2 | 06-01-2021 |
| | | | JP | 2017220615 A | 14-12-2017 |
| | | | KR | 20170139459 A | 19-12-2017 |
| | | | TW | 201809895 A | 16-03-2018 |
| | | | US | 2017358425 A1 | 14-12-2017 |
| JP H10106931 | A | 24-04-1998 | NONE | | |
| US 2019198290 | A1 | 27-06-2019 | JP | 2019114731 A | 11-07-2019 |
| | | | US | 2019198290 A1 | 27-06-2019 |
| US 2013143161 | A1 | 06-06-2013 | JP | 2013118060 A | 13-06-2013 |
| | | | US | 2013143161 A1 | 06-06-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6768125 B
- EP 2187427 A1
- US 8222621 B
- EP 2363875 A1
- US 8378320 B
- US 8546767 B
- US 6858118 B
- US 8198601 B
- US 10651010 B
- US 7276714 B
- US 9053906 B